# EUROPEAN PATENT SPECIFICATION

(11) **EP 1 017 643 B1**
(45) Date of publication and mention of the grant of the patent: **18.12.2002**
(21) Application number: 98939446.5
(22) Date of filing: 10.08.1998
(51) Int. Cl.: C03C 17/09, C03C 17/36, C03C 17/38, C23C 14/18

(54) **GLASS-BASED COPPER-MIRRORS**
KUPFERSPIEGEL AUF GLAS
MIROIRS A BASE DE CUIVRE ET DE VERRE

(30) Priority: 13.08.1997 GB 9717184
(43) Date of publication of application: 12.07.2000
(73) Proprietor: GLAVERBEL, B-1170 Bruxelles (BE)
(72) Inventor: DECROUPET, Daniel, B-5070 Fosses-la-Ville (BE); BOULANGER, Pierre, B-4218 Couthuin (BE)
(74) Representative: Vandenberghen, Lucienne
(86) International application number: BE9800123
(87) International publication number: WO99008972

(56) References cited:
- EP-A- 0 140 032
- EP-A- 0 559 967
- DE-A- 1 621 347
- DE-A- 4 220 621
- GB-A- 1 074 076
- GB-A- 1 115 911
- GB-A- 1 250 142
- GB-A- 2 102 453
- GB-A- 2 206 128
- GB-A- 2 252 568
- GB-A- 2 254 339
- US-A- 4 724 164

## Description

This invention relates to copper-based mirrors, especially for use in furnishings and decoration. It is particularly concerned with mirrors in which a copper layer is deposited by vacuum deposition on a vitreous substrate such as glass, for example by magnetron sputtering, evaporation under vacuum or ion plating.

Copper-based mirrors find use in applications such as furnishings and decoration because they are capable of giving an attractive appearance similar to that of gold while avoiding the high cost of using gold as such. The disadvantage is that while gold is inert and corrosion-resistant, copper is reactive and susceptible to oxidation, especially during the traditional mirror manufacturing procedures. This may result in visual defects including discoloration or haze in the reflective layer, which defects tend to increase with continued exposure to the atmosphere. Various proposals have therefore been made to protect copper mirrors against such undesired effects.

One frequently proposed anti-corrosion method, mentioned in GB patent specifications Nos. 1074076, 1250142 and 2102453, has been to treat the copper with a substituted azole, for example aminotetrazole, so as to create a protective coating on the copper surface. So-treated copper layers are however prone to changes in aspect both during and after the manufacture of the mirror. GB patent specification 2206128 addresses the problem of such changes in aspect in an azole-treated copper layer by using chemical deposition to form the copper layer and including steps in the deposition procedure which ensure a low oxygen content in the copper. The internal oxygen content is thereby reduced to below that which would react with the copper to produce the undesired discoloration.

The use of chemical methods to apply a copper layer has recently come under increased scrutiny because of their adverse environmental effects. In particular the levels of sulphate and residues of copper as such tend to require complex clean-up systems in order to fall within the relevant health and safety limits. Attention has therefore been directed to new methods of applying a copper coating to a vitreous substrate to meet the defined standards.

We have surprisingly found that the technique of applying the copper by vacuum deposition not only satisfies the requisite health and safety standards but also when combined with a particular means for preparing the substrate to receive the copper provides a mirror of consistently high quality and of unusually attractive appearance.

According to the invention there is provided a method of producing a mirror comprising a transparent vitreous substrate and a reflective copper layer, characterised in that:
(a) the substrate is treated with an aqueous solution of stannous chloride prior to the formation of the copper layer, and
(b) the so-treated substrate is covered by a reflective copper layer which is applied by vacuum deposition to a thickness of at least 40 nm.

The scope of the invention extends to a mirror produced by the said method.

The method of the invention offers several important benefits. The direct application of a copper layer to the treated substrate achieves a mirror in a single coating step, with associated convenience and simplicity of the coating operation. There is no intermediate layer deposition step between steps (a) and (b), and no need for such a step. Moreover the copper layer deposited by vacuum deposition has good resistance to chemical or mechanical corrosion despite the absence of any associated underlayers and even in the absence of any associated overlayers.

The use of vacuum deposition also avoids health and safety problems associated with chemical deposition methods.

A particular benefit of the invention is that the use of vacuum deposition affords fine control over the copper thickness, thereby permitting the copper layer to be easily applied in a desired thickness. The preferred version of vacuum deposition for the purposes of the invention is magnetron sputtering.

The specified thickness of at least 40 nm for the reflective layer of copper has the advantage of ensuring the properties of reflection and opacity sought for a mirror. The luminous reflectance of the copper layer is greater than 40% and its luminous transmission is very low, for example from 0 to 2%. Preferably the thickness of the reflective layer of copper is at least 50 nm.

The copper preferably has a purity of substantially 100%. The copper layer may however contain traces of copper oxide if the deposition atmosphere contains traces of oxygen.

The copper thickness is preferably in the range 60 to 80 nm, most preferably 67 to 77 nm. The reflectance of the copper layer reaches a maximum within the range 60 to 80 nm. A thickness in the latter range is thus of particular benefit in providing for mirrors of reproducible, consistent, uniform high quality. The thickness is most preferably 67 to 77 nm because the reflectance of the copper layer is at a consistently high level in this range. Despite the relatively high thickness of the copper layer this does not impose an undue level of additional material costs.

The coated mirror preferably has a reflectance (measured from the glass side) in the range 45 to 65%. Its Hunter colour coordinates a and b are preferably in the ranges 10 to 20 and 10 to 25 respectively.

The concentration of the stannous chloride solution is preferably in the range 100 to 150 mg/l. In some instances it may be beneficial for the solution to be acidic, in order to enhance the sensitising effect of the stannous chloride on the substrate.

Prior to application of the stannous chloride solution it is desirable to ensure that the substrate is thoroughly clean, including if necessary a step of washing with a detergent solution, followed by rinsing and optionally by drying.

The vitreous substrate is most typically a sheet of soda lime glass, either coloured or colourless. As a first step in preparing the glass for the stannous chloride application it may be desirable to polish the glass, for example with cerium oxide and/or calcium carbonate powders. Polishing helps in achieving a smooth base surface. It should best be followed by rinsing with demineralised water, which can if required be assisted by the use of brushes such as rotary brushes. If necessary other possible pre-treatment can be employed to assist removal of any excessive concentration of alkali metal ions, especially sodium, which may have arisen at the glass surface.

After application of the stannous chloride solution the substrate is again preferably rinsed with demineralised water. If desired the substrate can be further pre-treated with a dilute aqueous solution of silver nitrate, again preferably followed by rinsing with demineralised water. The silver nitrate concentration should preferably be in the range 200 to 500 mg/l.

If desired one or more overlayers may be deposited on the copper layer, again being applied by vacuum deposition. While not essential, such an overlayer has the benefit of improving the resistance of the coating to damage by adhesives. Suitable materials for the overlayer(s) include a transparent or absorbent material selected from oxides, nitrides, carbides, oxynitrides and oxycarbides, applied by vacuum deposition.

Examples of suitable transparent oxides for the overlayer include alumina (Al₂O₃), hafnium oxide (HfO₂), niobium oxide (NbO), silicon oxide (SiO₂), stannic oxide (SnO₂), tantalum oxide (Ta₂O₅), titanium dioxide (TiO₂) and zinc oxide (ZnO). Examples of suitable transparent nitrides include aluminium nitride (A1N) and silicon nitride (Si₃N₄). Examples of suitable absorbent materials include stainless steel oxide *(SSOx),* chromic oxide (Cr₂O₃), iron oxides (Fe₂O₃ or Fe₃O₄), nickel oxide (NiO), nickel-chrome oxide and silicon carbide (SiC).

If an overlayer, especially an oxide overlayer, is employed then a layer of titanium metal, typically of 3 to 5 nm thickness, may also be deposited between the copper and the overlayer. The titanium layer too should preferably be applied by vacuum deposition. The deposited titanium acts as a scavenger for oxygen which might otherwise reach the copper. As the titanium used in this role is expected to be progressively converted to oxide it is usually described as a sacrificial metal.

The use of vacuum deposition for all the aforementioned layers makes for simple application of the coating layers and ensures a high quality deposit for each of them.

The mirror coating may further comprise an outer paint layer. In order to meet the highest environmental standards the paint is preferably lead-free and is preferably applied by a powder deposition method. If desired the paint can include a corrosion inhibitor such as 5-aminotetrazole (ATA). It is however found that the coating of the invention has a high level of resistance which permits in particular the storage and transport of unpainted mirrors without harming them. The paint layer provides additional corrosion resistance and increases the opacity of the reflective copper layer. It should however be noted that the high opacity of the reflective copper layer as discussed above (i.e. luminous transmission of not more than 2%) is achieved even in the absence of a paint layer.

It is a particular benefit of the method of the invention that it is generally unnecessary to employ any overlayers of materials such as oxides and nitrides. The reason appears to be that the stannous chloride treatment provides a very clean and "sensitised" surface to which the copper bonds strongly and evenly. The so-prepared surface state for receiving the copper is an important factor in providing corrosion resistance.

In embodiments of the invention for making decorative mirrors a mask or masks can be employed during the deposition of the copper, and of any further layers, so as to create a chosen pattern or other design.

The invention is further described in the following nonlimiting examples, in which the substrate was sheets of soda-lime glass measuring 40 x 30 cm and having a thickness of 6 mm. Example 1 and comparative example 2 were conducted under laboratory conditions. Examples 2, 3 and comparative example 1 were conducted under industrial conditions.

### Example 1

A soda-lime glass sheet was polished with cerium oxide, thoroughly rinsed by spraying with demineralised water and then dried in a stream of gaseous nitrogen. The sheet was then sprayed with an aqueous solution of 120 mg/l stannous chloride (*London Laboratories' RNA*), again followed by spraying with demineralised water and drying. Finally the sheet was sprayed with an aqueous solution of 400 mg/l silver nitrate, rinsed and dried.

The sheet was then fed through a vacuum treatment chamber in which a layer of copper was applied by magnetron sputtering. The thickness of the copper layer is shown in the accompanying table. The so-coated sheet was removed from the vacuum chamber and then cut into two samples of 15 x 40 cm. One of the samples (1a) was placed in a paint chamber for the deposition of first a primer paint layer (*Merckens SK 9165*) by curtain-coating apparatus and baked for 10 minutes at 55°C to give a dry layer thickness of 30 µm. A finishing paint layer (*Merckens SK 9240*) was deposited by pulverisation and baked for 10 minutes at 150°C to give a total paint thickness of 95 µm.

The other sample (1b) was first immersed for 5 minutes in a 10 g/l solution of 5-aminotetrazole (ATA) at a temperature of 80°C and then painted in the same manner as for sample 1(a), giving a paint thickness of 85 µm.

Both samples were then tested for optical and corrosion properties, including Hunter values L , a & b and luminous reflectance R [R = (L/10)²), and exposed to a CASS test of accelerated weathering for 120 hours to determine loss of reflectance (given in absolute percentages), and levels of corrosion (average and maximum). The procedure is summarised in the accompanying Table which also shows the test results obtained.

The layer thicknesses were determined by an X-ray fluorescence technique. This measures the number of impulses from the layer. The result is obtained in units of mass per unit area, e.g. mg/m². Given that the density and uniformity of the layer material are known the said result can be used to calculate a good approximation of the thickness. For copper the thickness in nm is given by dividing the value in mg/m² units by 8.9.

In all the optical tests described in the examples herein the measurements were taken from the glass side.

The CASS Test, which is defined in International Standard ISO 3770-1976, includes placing the mirror in a test chamber at 50°C and subjecting it to the rapid ageing action of a spray mist of an aqueous solution containing 50 g/l sodium chloride, 0.2 g/l anhydrous cuprous chloride and glacial acetic acid in a sufficient quantity to give the spray a pH of between 3.0 and 3.1. The reflective properties of the mirror artificially aged by this aqueous acidic saline solution are compared with the reflective properties of the freshly formed mirror.

### Examples 2 and 3

The process of Example 1 (sample 1a) was generally followed for further examples 2 to 3, with the following differences. The cerium oxide treatment step was replaced by washing with a potassium polyphosphate detergent (*Chemical Products' RBS 50*), followed by thorough rinsing with demineralised water and drying with a hot air stream. After the application of the copper layer the substrate was further coated with 3 nm of titanium metal, followed by a defined thickness of stannic oxide, both materials being applied by magnetron sputtering. Painting was not preceded by an ATA treatment. The paints used to form the primer and finishing paint layers were *Levis* alkyd paints (*9471010* and *9471064*). The finished paint layer had a smaller thickness than for Example 1. The Hunter values were measured during manufacture of the mirror, prior to the painting. This does not significantly affect these values as they are little changed by the painting.

The specific parameters and thicknesses for examples 2 and 3, and the results obtained are shown in the accompanying Table. The high levels of corrosion compared with Example 1 may result from the presence of the Ti/SnO₂ overlayer and the greater stresses that arise in the paint at the interface with this overlayer compared with the low stresses in a direct interface with the copper layer.

In examples 1 to 3, the luminous transmission value of the mirror before painting was from 1 to 1.5%.

### Comparative Example 1

Comparative example 1 employed most of the process steps of Example 2: washing with a potassium polyphosphate detergent (*RBS 50*), followed by thorough rinsing with demineralised water and drying with isopropyl alcohol, applying a layer of copper by magnetron sputtering under vacuum, removing the so-coated sheet from the vacuum chamber. However it omitted the treatments with stannous chloride and silver nitrate. The omission had a severe effect on the product quality, a haze being immediately formed by contact with the atmosphere after deposition of the copper layer, which prevented testing of the optical and corrosion qualities.

### Comparative Example 2

The process of Example 1 (sample 1a) was followed, except that the copper was applied by traditional chemical deposition instead of by magnetron sputtering. No coating of titanium metal or stannic oxide was applied. The whole sheet was treated with ATA and then painted with a single layer of finishing paint having a thickness of 44.0 µm.

The sheet was subjected to the tests described above. The results, also given in the Table, show that compared with the samples treated according to the invention the sheet displayed inferior Hunter values and lower reflectance after the CASS test. The corrosion resistance was below that of Example 1 samples 1a and 1b.

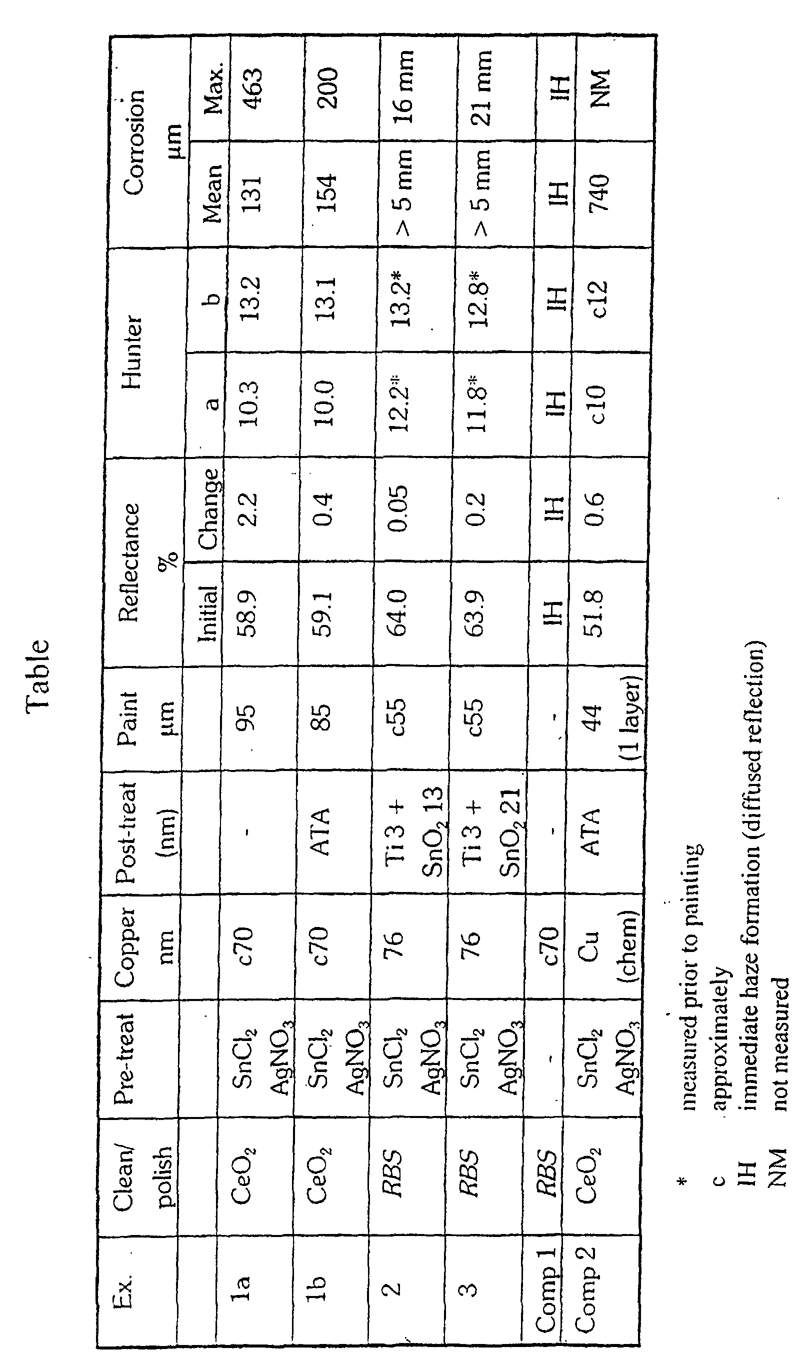

## Claims

1. A method of producing a mirror comprising a transparent vitreous substrate and a reflective copper layer, **characterised in that**:
(a) the substrate is treated with an aqueous solution of stannous chloride prior to the formation of the copper layer, and
(b) the so-treated substrate is covered by a reflective copper layer which is applied by vacuum deposition to a thickness of at least 40 nm.

2. A method of producing a mirror according to claim 1 in which the copper layer is directly applied to the treated substrate.

3. A method as claimed in claims 1 or 2 in which the copper has a purity of substantially 100%,

4. A method as claimed in any of claims 1 to 3, in which the copper is deposited to a thickness in the range 60 to 80 nm.

5. A method as claimed in claim 4, in which the copper is deposited to a thickness in the range 67 to 77 nm.

6. A method as claimed in any preceding claim, in which the concentration of the stannous chloride solution is in the range 100 to 150 mg/l.

7. A method as claimed in claim 6, in which the stannous chloride solution is acidic.

8. A method as claimed in any preceding claim, in which the substrate is prepared for the stannous chloride application by polishing with cerium oxide and/or calcium carbonate powders.

9. A method as claimed in any preceding claim, in which after application of the stannous chloride solution the substrate is treated with a dilute aqueous solution of silver nitrate.

10. A method as claimed in claim 9, in which the silver nitrate concentration is in the range 200 to 500 mg/l.

11. A method as claimed in any preceding claim in which the copper layer has a luminous reflectance greater than 40%.

12. A method as claimed in any preceding claim in which the copper layer has a luminous transmission lower than or equal to 2%.

13. A method as claimed in any preceding claim, in which one or more overlayers are deposited on the copper layer by vacuum deposition.

14. A method as claimed in claim 13, in which the material of the or each overlayer is at least one selected from the group of transparent oxides consisting of alumina (Al₂O₃), hafnium oxide (HfO₂), niobium oxide (NbO), silicon oxide (SiO₂), stannic oxide (SnO₂), tantalum oxide (Ta₂O₅), titanium dioxide (TiO₂) and zinc oxide (ZnO), transparent nitrides such as aluminium nitride (AlN) and silicon nitride (Si₃N₄) and absorbent materials such as stainless steel oxide *(SSOx)*, chromic oxide (Cr₂O₃), iron oxides (Fe₂O₃ or Fe₃O₄), nickel oxide (NiO), nickel-chrome oxide and silicon carbide (SiC).

15. A method as claimed in claim 14, in which a layer of titanium metal is deposited by vacuum deposition between the copper and the overlayer.

16. A method as claimed in any preceding claim, in which an outer paint layer is applied.

17. A method as claimed in claim 16, in which the paint is applied from powder.

18. A method as claimed in claim 16 or claim 17, in which the paint is lead-free.

19. A mirror obtainable by a method according to any preceding claim.

20. A mirror comprising a transparent vitreous substrate and a reflective copper layer, **characterized in that** traces of tin and traces of chloride are present at the surface of the vitreous substrate.

21. A mirror as claimed in claim 19 or claim 20, in which the copper layer has a thickness in the range 60 to 80 nm.

22. A mirror as claimed in claim 21, in which the copper layer has a thickness in the range 67 to 77 nm.

23. A mirror as claimed in any one of claims 19 to 22, which further comprises an overlayer of a transparent or absorbent material selected from oxides, nitrides, carbides, oxynitrides and oxycarbides, applied by vacuum deposition.

24. A mirror as claimed in claim 23, in which the material of the or each overlayer is at least one selected from the group of transparent oxides consisting of alumina (Al₂O₃), hafnium oxide (HfO₂), niobium oxide (NbO), silicon oxide (SiO₂), stannic oxide (SnO₂), tantalum oxide (Ta₂O₅), titanium dioxide (TiO₂) and zinc oxide (ZnO), transparent nitrides such as aluminium nitride (AlN) and silicon nitride (Si₃N₄) and absorbent materials such as stainless steel oxide *(SSOx)*, chromic oxide (Cr₂O₃), iron oxides (Fe₂O₃ or Fe₃O₄), nickel oxide (NiO), nickel-chrome oxide and silicon carbide (SiC).

25. A mirror as claimed in claim 23 or claim 24, which further comprises between the copper layer and overlayer a layer of titanium metal, applied by vacuum deposition.

26. A mirror as claimed in claim 25, in which the layer of titanium metal has a thickness in the range 3 to 5 nm.

27. A mirror as claimed in any of claims 19 to 26, which further comprises an outer layer of paint.

28. A mirror as claimed in claim 27, in which the paint is applied from powder.

29. A mirror as claimed in claim 27 or claim 28, in which the paint is lead-free.

30. A mirror as claimed in any of claims 19 to 29, which has a reflectance (measured from the glass side) in the range 45 to 65%.

31. A mirror as claimed in any of claims 19 to 30, having Hunter colour coordinates a and b in the ranges 10 to 20 and 10 to 25 respectively.

## Patentansprüche

1. Verfahren zum Herstellen eines Spiegels, umfassend ein transparentes glasartiges Substrat und eine reflektierende Kupferschicht, **dadurch gekennzeichnet, daß**
(a) das Substrat vor der Bildung der Kupferschicht mit einer wäßrigen Lösung von Zinn(II)chlorid behandelt wird und
(b) das so behandelte Substrat mit einer reflektierenden Kupferschicht, die durch Vakuumabscheidung in einer Dicke von mindestens 40 nm aufgebracht wird, bedeckt wird.

2. Verfahren zum Herstellen eines Spiegels nach Anspruch 1, worin die Kupferschicht direkt auf das behandelte Substrat aufgebracht wird.

3. Verfahren nach Anspruch 1 oder 2, wobei das Kupfer eine Reinheit von im wesentlichen 100% aufweist.

4. Verfahren nach einem der Ansprüche 1 bis 3, worin das Kupfer in einer Dikke im Bereich von 60 bis 80 nm abgeschieden wird.

5. Verfahren nach Anspruch 4, worin das Kupfer in einer Dicke im Bereich von 67 bis 77 nm abgeschieden wird.

6. Verfahren nach einem vorhergehenden Anspruch, wobei die Konzentration der Zinn(II)chloridlösung im Bereich von 100 bis 150 mg/l ist

7. Verfahren nach Anspruch 6, wobei die Zinn(II)chloridlösung sauer ist.

8. Verfahren nach einem vorhergehenden Anspruch, worin das Substrat für das Aufbringen der Zinn(II)chloridlösung durch Polieren mit Ceroxid- und/oder Calciumcarbonatpulvem behandelt wird.

9. Verfahren nach einem vorhergehenden Anspruch, worin das Substrat nach Aufbringen der Zinn(II)chloridlösung mit einer verdünnten wäßrigen Lösung von Silbemitrat behandelt wird.

10. Verfahren nach Anspruch 9, wobei die Silbemitratkonzentration im Bereich von 200 bis 500 mg/l ist.

11. Verfahren nach einem vorhergehenden Anspruch, wobei die Kupferschicht eine Lichtreflexion von mehr als 40% aufweist

12. Verfahren nach einem vorhergehenden Anspruch, wobei die Kupferschicht eine Lichtdurchlässigkeit von weniger als oder gleich 2% aufweist.

13. Verfahren nach einem vorhergehenden Anspruch, worin ein oder mehrere Überzüge auf der Kupferschicht durch Vakuumabscheidung abgeschieden werden.

14. Verfahren nach Anspruch 13, wobei das Material des oder jedes Überzugs mindestens eines, ausgewählt aus der Gruppe transparenter Oxide, bestehend aus Aluminiumoxid (Al₂O₃), Hafniumoxid (HfO₂), Nioboxid (NbO), Siliciumoxid (SiO₂), Zinnoxid (SnO₂), Tantaloxid (Ta₂O₅), Titanoxid (TiO₂) und Zinkoxid (ZnO), transparenter Nitride wie Aluminiumnitrid (AIN) und Silciumnitrid (Si₃N₄), und Absorptionsmaterialien wie Edelstahloxid (SSOx), Chromoxid (Cr₂O₃), Eisenoxiden (Fe₂O₃ oder Fe₃O₄), Nickeloxid (NiO), Nickel-Chromoxid und Siliciumcarbid (SiC), ist.

15. Verfahren nach Anspruch 14, worin eine Schicht von Titanmetall durch Vakuumabscheidung zwischen der Kupferschicht und dem Überzug abgeschieden wird.

16. Verfahren nach einem vorhergehenden Anspruch, worin eine äußere Anstrichschicht aufgebracht wird.

17. Verfahren nach Anspruch 16, worin der Anstrich aus Pulver aufgebracht wird.

18. Verfahren nach Anspruch 16 oder 17, wobei der Anstrich bleifrei ist,

19. Spiegel, erhältlich durch ein Verfahren nach einem vorhergehenden Anspruch.

20. Spiegel, umfassend ein transparentes glasartiges Substrat und eine reflektierende Kupferschicht, **dadurch gekennzeichnet, daß** Spuren von Zinn und Spuren von Chlorid in der Oberfläche des glasartigen Substrates vorliegen.

21. Spiegel nach Anspruch 19 oder 20, wobei die Kupferschicht eine Dicke im Bereich von 60 bis 80 nm aufweist.

22. Spiegel nach Anspruch 21, wobei die Kupferschicht eine Dicke im Bereich von 67 bis77 nm aufweist.

23. Spiegel nach einem der Ansprüche 19 bis 22, der weiter einen durch Vakuumabscheidung aufgebrachten Überzug eines transparenten oder absorbierenden Materials, ausgewählt aus Oxiden, Nitriden, Carbiden, Oxynitriden . und Oxycarbiden, umfaßt.

24. Spiegel nach Anspruch 23, wobei das Material des oder jedes Überzugs mindestens eines, ausgewählt aus der Gruppe transparenter Oxide, bestehend aus Aluminiumoxid (Al₂O₃), Hafniumoxid (HfO₂), Nioboxid (NbO), Siliciumoxid (SiO₂), Zinnoxid (SnO₂), Tantaloxid (Ta₂O₅), Titanoxid (TiO₂) und Zinkoxid (ZnO), transparenter Nitride wie Aluminiumnitrid (AIN) und Silciumnitrid (Si₃N₄), und Absorptionsmaterialien wie Edelstahloxid (SSOx), Chromoxid (Cr₂O₃), Eisenoxiden (Fe₂O₃ oder Fe₃O₄), Nickeloxid (NiO), Nickel-Chromoxid und Siliciumcarbid (SiC), ist.

25. Spiegel nach Anspruch 23 oder 24, der weiter eine durch Vakuumabscheidung aufgebrachte Schicht von Ttanmetall zwischen der Kupferschicht und dem Überzug umfaßt.

26. Spiegel nach Anspruch 25, wobei die Schicht von Titanmetall eine Dicke im Bereich von 3 bis 5 nm aufweist.

27. Spiegel nach einem der Ansprüche 19 bis 26, der weiter eine äußere Anstrichschicht umfaßt.

28. Spiegel nach Anspruch 27, wobei der Anstrich aus Pulver aufgebracht ist.

29. Spiegel nach Anspruch 27 oder 28, wobei der Anstrich bleifrei ist.

30. Spiegel nach einem der Ansprüche 19 bis 29, der ein Reflexionsvermögen (gemessen von der Glasseite) im Bereich von 45 bis 65% aufweist.

31. Spiegel nach einem der Ansprüche 19 bis 30, der Hunter-Farbkoordinaten a und b in den Bereichen von 10 bis 20 bzw. 10 bis 25 aufweist.

## Revendications

1. Une méthode de fabrication d'un miroir comprenant un substrat vitreux transparent et une couche de cuivre réfléchissante, **caractérisée en ce que**:
(a) le substrat est traité avec une solution aqueuse de chlorure stanneux avant la formation de la couche de cuivre, et
(b) le substrat ainsi traité est recouvert par une couche de cuivre réfléchissante qui est appliquée par dépôt sous vide à une épaisseur d'au moins 40 nm.

2. Une méthode de fabrication d'un miroir selon la revendication 1 dans laquelle la couche de cuivre est appliquée directement au substrat traité.

3. Une méthode selon les revendications 1 ou 2 dans laquelle le cuivre a une pureté de substantiellement 100%.

4. Une méthode selon l'une quelconque des revendications 1 à 3 dans laquelle le cuivre est déposé à une épaisseur dans la gamme de 60 à 80 nm.

5. Une méthode selon la revendication 4 dans laquelle le cuivre est déposé à une épaisseur dans la gamme de 67 à 77 nm.

6. Une méthode selon l'une quelconque des revendications précédentes dans laquelle la concentration de la solution de chlorure stanneux est dans la gamme de 100 à 150 mg/l.

7. Une méthode selon la revendication 6 dans laquelle la solution de chlorure stanneux est acide.

8. Une méthode selon l'une quelconque des revendications précédentes dans laquelle le substrat est préparé pour l'application du chlorure stanneux en polissant avec de l'oxyde de cérium et/ou des poudres de carbonate de calcium.

9. Une méthode selon l'une quelconque des revendications précédentes dans laquelle après l'application de la solution de chlorure stanneux, le substrat est traité avec une solution aqueuse diluée de nitrate d'argent.

10. Une méthode selon la revendication 9 **caractérisée en ce que** la concentration en nitrate d'argent est dans la gamme de 200 à 500 mg/l.

11. Une méthode selon l'une quelconque des revendications précédentes dans laquelle la couche de cuivre a une réflectance lumineuse supérieure à 40%.

12. Une méthode selon l'une quelconque des revendications précédentes dans laquelle la couche de cuivre a une transmission lumineuse inférieure ou égale à 2%.

13. Une méthode selon l'une quelconque des revendications précédentes dans laquelle une ou plusieurs surcouches sont déposées sur la couche de cuivre par dépôt sous vide.

14. Une méthode selon la revendication 13, dans laquelle le matériau de la ou de chaque surcouche est au moins un sélectionné du groupe d'oxydes transparents constitué par l'alumine (Al₂O₃), l'oxyde d'hafnium (hfO₂), l'oxyde de niobium (NbO), l'oxyde de silicium (SiO₂), l'oxyde stannique (SnO₂), l'oxyde de tantale (Ta₂O₅), l'oxyde de titane (TiO₂) et l'oxyde de zinc (ZnO), de nitrures transparents tels que le nitrure d'aluminium (AlN) et le nitrure de silicium (Si₃N₄) et de matériaux absorbants tel que l'acier inoxydable *(SSOx)*, l'oxyde chromique (Cr₂O₃), les oxydes de fer (Fe₂O₃ or Fe₃O₄), l'oxyde de nickel (NiO), l'oxyde de nickel-chrome et le carbure de silicium (SiC).

15. Une méthode selon la revendication 14 dans laquelle une couche de titane métallique est déposée par dépôt sous vide entre le cuivre et la surcouche.

16. Une méthode selon l'une quelconque des revendications précédentes dans laquelle une couche de peinture externe est appliquée.

17. Une méthode selon la revendication 16 dans laquelle la peinture est appliquée à partir d'une poudre.

18. Une méthode selon la revendication 16 ou la revendication 17 dans laquelle la peinture est sans plomb.

19. Un miroir susceptible d'être obtenu par une méthode selon l'une quelconque des revendications précédentes.

20. Un miroir comprenant un substrat vitreux transparent et une couche de cuivre réfléchissante, **caractérisé en ce que** des traces d'étain et des traces de chlorure sont présentes à la surface du substrat vitreux.

21. Un miroir selon la revendication 19 ou la revendication 20 dans lequel la couche de cuivre a une épaisseur dans la gamme de 60 à 80 nm.

22. Un miroir selon la revendication 21 dans lequel la couche de cuivre a une épaisseur dans la gamme de 67 à 77 nm.

23. Un miroir selon l'une quelconque des revendications 19 à 22 qui comprend en plus une surcouche, appliquée par dépôt sous vide, d'un matériau transparent ou absorbant, sélectionné parmi les oxydes, nitrures, carbures, oxynitrures et oxycarbures.

24. Un miroir selon la revendication 23 dans lequel le matériau de la ou de chaque surcouche est au moins un sélectionné du groupe d'oxydes transparents constitué par l'alumine (Al₂O₃), l'oxyde d'hafnium (HfO₂), l'oxyde de niobium. (NbO), l'oxyde de silicium (SiO₂), l'oxyde stannique (SnO₂), l'oxyde de tantale (Ta₂O₅), l'oxyde de titane (TiO₂) et l'oxyde de zinc (ZnO), de nitrures transparents tels que le nitrure d'aluminium (AlN) et le nitrure de silicium (Si₃N₄) et de matériaux absorbants tel que l'acier inoxydable *(SSOx)*, l'oxyde chromique (Cr₂O₃), les oxydes de fer (Fe₂O₃ or Fe₃O₄), l'oxyde de nickel (NiO), l'oxyde de nickel-chrome et le carbure de silicium (SiC).

25. Un miroir selon la revendication 23 ou la revendication 24 qui comprend en plus entre la couche de cuivre et la surcouche, une couche de titane métallique appliquée par dépôt sous vide.

26. Un miroir selon la revendication 25 dans lequel le titane métallique a une épaisseur dans la gamme de 3 à 5 nm.

27. Un miroir selon l'une quelconque des revendications 19 à 26 qui comprend en plus une couche de peinture externe.

28. Un miroir selon la revendication 27 dans lequel la peinture est appliquée à partir d'une poudre.

29. Un miroir selon la revendication 27 ou la revendication 28 dans lequel la peinture est sans plomb.

30. Un miroir selon l'une quelconque des revendications 19 à 29 qui a une réflectance (mesurée du côté verre) dans la gamme de 45 à 65%.

31. Un miroir selon l'une quelconque des revendications 19 à 30 ayant les coordonnées de couleur de Hunter a et b respectivement dans les gammes de 10 à 20 et de 10 à 25.
